# EUROPEAN PATENT APPLICATION

(11) **EP 0 600 516 A1**
(43) Date of publication of application: **08.06.1994**
(21) Application number: 93119553.1
(22) Date of filing: 03.12.1993
(51) Int. Cl.: C23C 16/44

(54) **Diffusion furnace boat assembly and wafer support**

(30) Priority: 03.12.1992 US 986161
(71) Applicant: Saint-Gobain/Norton Industrial Ceramics Corporation, Worcester, MA 01615-0008 (US)
(72) Inventor: Proia, Stephen E., Worcester, MA 01606 (US); Foster, Bryan D., Holden, MA 01520 (US)
(74) Representative: DIEHL GLAESER HILTL & PARTNER

(57) **Abstract**

Described is a vertical rack or boat assembly for supporting and carrying semi-conductor material wafers in a vertical diffusion furnace, the assembly being made up of a rack or boat (1) and wafer support rings (5) which fit into the boat (1).

## Description

The invention relates to a diffusion furnace boat assembly and a wafer support.

One phase in the manufacture of semi-conductor devices such as diodes, transistors, and integrated circuits involves the high temperature oxidation, diffusion and/or deposition of thin layers of materials on, for example, silicon wafers. Such processing has been carried out in a variety of equipment types such as those described in U.S. Patents No. 3,436,255; No. 4,761,134; and No. 4,802,842.

The first patent concerns the treatment of silicon wafers or the like by first placing the wafers in a refractory rack or boat, which is then located on a transporter or carrier which in turn is placed into a process tube. This entire assembly is then moved into a horizontal muffle furnace which is supplied with heat and the appropriate gas.

The second patent refers to a heating element, made of graphite, for an epitaxial deposition furnace. The heating element is essentially flat and rectangular in shape with the wafers to be treated being placed in recesses or depressions in the surface of the graphite heating element, the depressions having a diameter only slightly larger than the diameter of the wafers to be processed. In one embodiment, the recesses or depressions have a shoulder of a somewhat smaller diameter than that of the recess; in this embodiment the wafers rest on the shoulder. Support rings for holding the wafers are also disclosed, the support rings being of a size and configuration to fit into the recesses in the heating element.

U.S. Patent No. 4,802,842 relates to a rack or boat for holding semi-conductor wafer material in the newer type of diffusion furnace which is a vertically oriented furnace and reaction chamber rather than the older type horizontal furnace such as that described in U.S. Patent No. 4,761,134. As is evident from Figures 1, 2, and 3, the relevant disclosure of the reference is a boat or rack which stands vertically, made up of at least three posts with either slots in the posts into which silicon wafers are inserted, or protrusions on the posts upon which the wafers sit during processing, the boat or rack carrying the wafers having been inserted into a vertical furnace. While this vertical boat is clearly an improvement over the prior art, it does exhibit one serious shortcoming viz. because the wafers are supported only on three relatively small surfaces, the resulting wafers emerge from the process at least substantially stressed/strained and sometimes even distorted as a result of such effectively point contact on the edge of the wafers.

It is therefore the object of the present invention to provide a diffusion furnace boat assembly and a wafer support which avoid the above mentioned drawbacks. This object is solved by the boat assembly according to independent claim 1 and the wafer support according to independent claim 5. Further advantageous features, aspects and details of the invention are evident from the dependent claims, the description and the drawings. The claims are to be understood as a first non-limiting approach to define the invention in general terms.

The invention relates to a vertical diffusion furnace boat assembly used to manufacture semi-conductor devices and more particularly, racks or boats used to carry semi-conductor substrates and support means for such substrates.

The invention refers to a refractory boat and mating supports for the processing of wafers of semi-conductor material. The boat is of the vertical type, i.e. configured to fit into a vertical diffusion furnace, and is made up of a high purity refractory material such as high purity sintered silicon carbide, silicon impregnated silicon carbide, silicon nitride, quartz, alumina, or zirconia, and including any of the foregoing coated with a high purity impervious coating of silicon carbide, silicon nitride, or the like. The wafer supports which are preferably composed of the same material as the boat, are especially adapted to fit into the vertical boat and to carry wafers of semi-conductor material such as silicon. The wafer supports are most conveniently round rings of refractory material which may be split or solid. However, the supports may be a solid disc and may be shapes other than round, e.g. hexagonal, or even square, if the design of the boat will accept such configurations.

Figure 1 is an elevated side view of a boat assembly for processing semi-conductor materials wafers, including wafer supports.

Figure 2 is a sectional top view of the boat assembly of Figure 1, taken on line 2-2 of Figure 1.

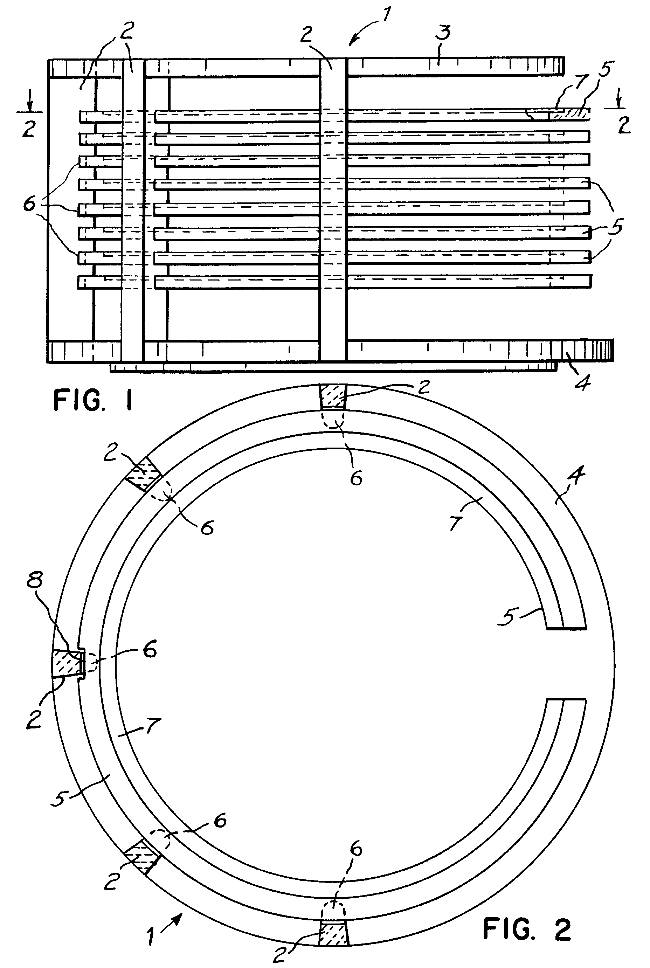

Referring to the drawing, Figure 1 is a boat assembly according to the invention, showing the boat per se as 1 and, wafer supports 5. The boat 1 is made up of a top plate 3, a bottom plate 4, and at least two and preferably three vertical posts or rods 2 which are joined to both bottom plate 4 and top plate 3. The rods or posts 2 include a series of slots 6 which are spaced equidistantly from the bottom plate 4 and are of such a dimension that they will accept and retain wafer support rings 5 in an essentially horizontal position. While the drawing shows the wafer support ring retaining means in the post 2 as slots 6, these retaining means could also be protrusions or ledges on each post, or even pins directed inwardly toward the center of the boat 1.

The wafer support ring 5 in Figure 1 has a depression or recess 7 therein which is just slightly larger in diameter than the wafer which it is to carry. The depth of the recess is preferably just deep enough to prevent the wafer from moving on the support but may be deeper if desired. Figure 2 shows a section through the boat 1 of Figure 1 which presents the wafer support 5 in more detail and its interaction with the boat 1. The ring 5 is a split ring. The purpose of the split is to facilitate the robotic loading of the wafer support 5, and a wafer positioned thereon, into the slots 6 in the posts 2. The split ring 5 could therefore also be a solid ring or even a disc as opposed to a ring. The preferred support ring 5 shown in Figures 1 and 2 includes a recess 7 as shown. While this is the more desirable configuration, the ring may be flush on its upper surface, i.e. free of any depression or recess. If both sides of the wafer are to be treated, a disc would not be the most effective support. A still more preferable wafer support design would include one or more aligning notches 8 shown in the wafer support ring 5 in Figure 2. The notches 8 must be slightly larger in width than the width of the vertical rods or posts 2.

The boat 1 shown in Figures 1 and 2 is of such a size as to accommodate only eight wafer support rings 5. The boat, in fact, may be of any length that a given vertical furnace will accept. Similarly, the simple design of the boat 1 and wafer support 5 combination of Figures 1 and 2 are not to be considered as limiting in any manner. The boat which preferentially has a round cross section, could be hexagonal, octagonal, or even square, with complimentarily shaped wafer supports. The boat 1 may include, for example, a ring as part of or attached to top plate 3 to facilitate mechanized lowering of the boat assembly and wafers into an induction furnace.

## Claims

1. A diffusion furnace boat assembly for a vertical semi-conductor wafer furnace comprising wafer supports (5) and a vertical boat (1) with means for maintaining a plurality of said wafer supports (5) in a separated manner, said boat (1) and wafer supports (5) being composed of a high purity refractory material.

2. The boat assembly of Claim 1 wherein said wafer supports (5) are in the form of a solid ring.

3. The boat assembly of Claim 1 wherein said wafer supports (5) are in the form of a split ring.

4. The boat assembly of one of the preceding Claims, wherein said vertical boat (1) and said wafer supports (5) are composed of a material selected from the group consisting of silicon carbide, silicon impregnated silicon carbide, silicon carbide with an impervious refractory coating thereon, silicon impregnated silicon carbide with an impervious refractory coating thereon, quartz, silicon nitride, and zirconium oxide.

5. A wafer support (5) for use in conjunction with a boat (1) in a diffusion furnace, said wafer support (5) having a thin cross section relative to its width.

6. The wafer support (5) of Claim 5, said wafer support being a solid disc.

7. The wafer support (5) of Claim 5 or 6, having a recess (7) therein which accommodates a wafer.

8. The wafer support (5) of Claim 5 or 7, said wafer support (5) being a continuous ring.

9. The wafer support (5) of Claim 5 or 7, said wafer support (5) being a split ring.

10. The wafer support (5) of one of Claims 5 to 9, wherein said wafer support (5) is composed of a material selected from the group consisting of silicon carbide, silicon impregnated silicon carbide, silicon carbide with an impervious refractory coating thereon, silicon impregnated silicon carbide with an impervious refractory coating thereon, quartz, silicon nitride, and zirconium oxide.
